# DEMANDE DE BREVET EUROPEEN

(11) **EP 0 766 293 A2**
(43) Date de publication de la demande: **02.04.1997**
(21) Numéro de dépôt: 96410099.4
(22) Date de dépôt: 24.09.1996
(51) Int. Cl.: H01L 21/3205, H01L 21/329, H01C 17/26, H01L 21/28, H01L 21/3215

(54) **Procédé de modification du dopage d'une couche de silicium**

(30) Priorité: 28.09.1995 FR 9511626
(71) Demandeur: SGS-THOMSON MICROELECTRONICS S.A., 94250 Gentilly (FR)
(72) Inventeur: Kalnitsky, Alexander, 38000 Grenoble (FR); Lepert, Arnaud, 38920 Crolles (FR)
(74) Mandataire: de Beaumont, Michel

(57) **Abrégé**

L'invention concerne un procédé de modification du dopage d'une région ou couche de silicium dopé, comprenant les étapes consistant à revêtir la région ou couche de silicium (11) d'une couche de siliciure d'un métal réfractaire (14) ; et à chauffer la région d'interface entre le silicium et le siliciure à une température choisie.

Application à la fabrication d'une résistance ajustable ou d'un transistor MOS à tension de seuil ajustable.

## Description

La présente invention concerne un procédé de modification du dopage d'une région ou couche de silicium et son application à la fabrication de résistances ajustables ou de transistors MOS à tension de seuil ajustable.

Dans de nombreux types de circuits intégrés, on cherche à réaliser des résistances ajustables, dans le but d'obtenir des valeurs de résistances relativement précises et prédéterminées ou d'obtenir l'une ou l'autre de deux valeurs haute et basse de sorte que la résistance agisse sensiblement comme fusible. De même, dans de nombreux circuits intégrés, on cherche à réaliser des transistors MOS de divers types différant les uns des autres par leur tension de seuil. De nombreux procédés pour obtenir de telles résistances ajustables et de tels transistors à seuil ajustable sont bien connus mais présentent tous divers avantages et inconvénients.

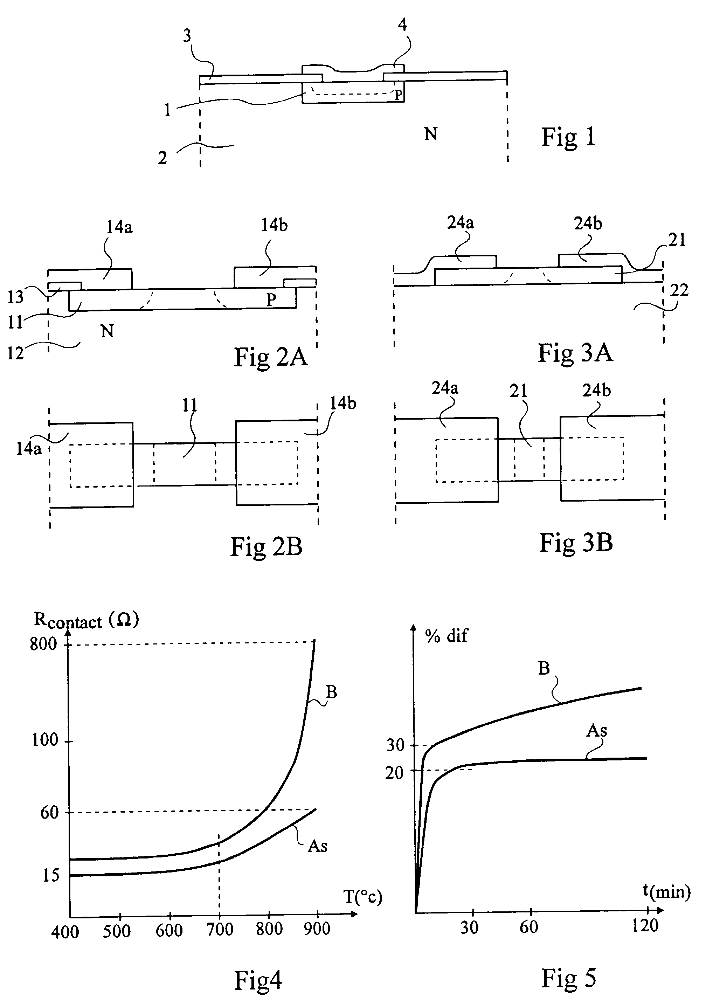

Par ailleurs, il est connu que, quand on cherche à réaliser un contact en siliciure sur un semiconducteur, la résistance de contact augmente si l'ensemble est soumis à un traitement thermique. Un exemple d'une telle structure est représenté en figure 1 dans laquelle une région 1 d'un premier type de conductivité est formée dans un substrat 2 ayant par exemple le type de conductivité opposé. La surface supérieure du substrat est isolée par une couche isolante 3, couramment de l'oxyde de silicium, et un siliciure 4 est formé dans l'ouverture. Un chauffage du siliciure provoque un appauvrissement en atomes dopants dans la zone voisine de l'interface siliciure-silicium. Ce phénomène est connu et est généralement considéré uniquement comme un inconvénient auquel on cherche à remédier de diverses façons, par exemple en prévoyant une couche superficielle surdopée, ou plus simplement en évitant de réaliser des étapes thermiques après formation du siliciure.

La présente invention vise à tirer partie de ce phénomène pour créer des résistances ajustables et des transistors à seuil ajustable.

Ainsi, un objet de la présente invention est de prévoir un procédé de réalisation d'une résistance ajustable, ce procédé étant particulièrement simple à mettre en oeuvre et compatible avec les technologies usuelles de circuit intégré.

Un autre objet de la présente invention est de prévoir un procédé de réalisation d'un transistor MOS à seuil ajustable, ce procédé étant particulièrement simple à mettre en oeuvre et compatible avec les technologies usuelles de circuit intégré.

Pour atteindre ces objets, la présente invention prévoit un procédé de modification du dopage d'une région ou couche de silicium dopé, comprenant les étapes consistant à revêtir la région ou couche de silicium d'une couche de siliciure d'un métal réfractaire ; et à chauffer la région d'interface entre le silicium et le siliciure à une température choisie.

Selon un mode de réalisation de la présente invention, le silicium est du silicium nonocristallin.

Selon un mode de réalisation de la présente invention, le silicium est du silicium polycristallin.

Selon un mode de réalisation de la présente invention, le siliciure est un siliciure de titane.

Selon un mode de réalisation de la présente invention, la température d'échauffement est comprise entre 750 et 1050°C.

Selon un mode de réalisation de la présente invention, le chauffage est réalisé par circulation de courant.

Selon un mode de réalisation de la présente invention, le chauffage est réalisé par irradiation optique, telle qu'une irradiation laser.

Selon un mode de réalisation de la présente invention, la région ou couche de silicium a une épaisseur comprise entre 100 et 400 nanomètres.

Selon un mode de réalisation de la présente invention, la région ou couche de silicium a un niveau de dopage de l'ordre de 5.10²⁰ atomes par cm³ et une résistance par carré de l'ordre de 1 à 3 ohms par carré.

Selon un mode de réalisation de la présente invention, la couche de siliciure a une épaisseur de l'ordre de 10 à 100 nm.

Dans une application à la fabrication d'une résistance ajustable, le procédé comprend les étapes consistant à prévoir une région ou couche de silicium ; à revêtir des extrémités de ladite région ou couche d'un siliciure ; et à chauffer les régions d'interface entre le silicium et le siliciure.

Dans une application à la fabrication d'un transistor MOS à tension de seuil ajustable, le procédé comprend les étapes consistant à former un transistor MOS dont la région de grille comprend un empilement d'un isolant de grille, de silicium polycristallin et d'une région de siliciure de titane ; et à chauffer les régions d'interface entre le silicium et le siliciure.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une structure de contact classique ;
les figures 2A et 2B sont respectivement une vue en coupe schématique et une vue de dessus schématique d'un premier mode de réalisation d'une résistance ajustable selon la présente invention ;
les figures 3A et 3B sont respectivement une vue en coupe schématique et une vue de dessus schématique d'un deuxième mode de réalisation d'une résistance ajustable selon la présente invention ;
la figure 4 représente la variation de la résistance de contact en fonction de la température pour des couches de silicium dopé respectivement au bore et à l'arsenic en contact avec une couche de siliciure de titane ;
la figure 5 représente un pourcentage d'exodiffusion en fonction du temps pour des couches de silicium respectivement dopé à l'arsenic et au bore à une température donnée ;
les figures 6A à 6C représentent respectivement une vue de dessus et des vues en coupe selon les lignes B-B et C-C de la figure 6A d'un transistor MOS à seuil ajustable selon la présente invention ; et
la figure 7 est un graphique illustrant la caractéristique courant-tension de drain d'un transistor MOS selon la présente invention soumis à diverses variations thermiques.

Comme cela est usuel dans le domaine des semiconducteurs, les diverses vues de dessus et en coupe de composants semiconducteurs ne sont pas tracées à l'échelle pour faciliter leur lisibilité et leur tracé.

La figure 2A représente une région de silicium 11 d'un premier type de conductivité formée dans un substrat 12 d'un deuxième type de conductivité. La périphérie de la région 11 est isolée superficiellement par une couche isolante 13, par exemple de l'oxyde de silicium. Une couche 14 de siliciure de titane (TiSi₂) est formée et gravée pour avoir sensiblement la configuration illustrée en figure 2B, c'est-à-dire que deux portions 14a et 14b recouvrent partiellement deux parties opposées de la région 11. Ainsi, si des contacts, par exemple en aluminium, sont formés sur les portions de siliciure 14a et 14b, on trouve entre ces contacts successivement la résistance du siliciure, la résistance d'interface siliciure-silicium, et la résistance du silicium.

Si on chauffe les régions d'interface siliciure-silicium, la résistance entre les régions 14a et 14b croît. On estime que cette augmentation de résistance est essentiellement due à une migration, une exodiffusion, des dopants contenus dans la région 11 vers les régions de siliciure 14a et 14b. Cette exodiffusion provoque une augmentation de résistance des régions correspondantes de silicium due à leur plus faible dopage et aussi une augmentation de la résistance d'interface, vraisemblablement due à une augmentation de la résistance de la couche de siliciure de titane liée à l'introduction dans celle-ci d'atomes dopants.

La figure 4 représente l'allure de la variation de résistance de contact en ohms en fonction de la température pour des régions 11 respectivement dopées à l'arsenic (As) et au bore (B). On voit que la résistance reste sensiblement constante tant que la température d'interface reste inférieure à 700°C puis que, quand cette température augmente au-delà de 700°C (ceci continue jusqu'à environ 1050°C), la résistance varie rapidement. Dans le cas de l'arsenic, on constate par exemple que la résistance passe de 15 à 60 ohms entre 700 et 900°C tandis que, dans le cas du bore, elle passe d'environ 25 à 800 ohms.

La figure 5 représente le pourcentage de diffusion en fonction du temps en minutes. On s'aperçoit que la diffusion s'effectue en un temps très court puis qu'il y a un phénomène de saturation dès que l'on dépasse une durée de l'ordre de la minute pour le bore et de la dizaine de minutes pour l'arsenic.

Selon la présente invention, deux moyens sont prévus pour échauffer l'interface siliciure/silicium. Le premier moyen consiste à faire circuler un courant entre les portions de siliciure 14a et 14b. Ce premier moyen permet un réglage relativement fin de l'échauffement et sera privilégié pour l'ajustement de valeur d'une résistance mais pourra également servir, par le passage d'un courant fort, à une augmentation importante de la valeur de résistance pour obtenir une résistance ayant une fonction de fusible. Le deuxième moyen consiste à irradier les zones concernées par un faisceau provoquant l'échauffement de l'interface. Ceci peut par exemple être réalisé par un laser dans une plage de longueurs d'onde correspondant à une zone de forte absorption des matériaux utilisés.

Dans le cas des figures 2A et 2B, on a représenté un premier mode de réalisation de la présente invention applicable à la formation d'une résistance ajustable constituée d'une région de silicium dopé formée dans un substrat de silicium de type opposé. On notera que le phénomène selon l'invention s'applique également au cas d'une couche de silicium polycristallin.

La figure 3A représente une bande de silicium 21, tel que du silicium polycristallin, sur un substrat isolant 22, par exemple une couche d'oxyde elle-même formée sur une tranche de silicium. Comme précédemment, les extrémités en regard de la bande de silicium polycristallin 21 sont revêtues de régions de siliciure de titane, respectivement 24a et 24b. On constate pour cette résistance, des phénomènes similaires à ceux décrits précédemment.

Cette réalisation est susceptible de nombreuses variantes qui apparaîtront à l'homme de métier. Par exemple, on pourra également utiliser du silicium dopé par d'autres dopants que l'arsenic ou le bore bien que ceux-ci soit actuellement préférés. Egalement, au lieu de siliciure de titane, on pourra utiliser un autre siliciure de métal réfractaire, par exemple un siliciure choisi dans le groupe comprenant le siliciure de tungstène, le siliciure de cobalt et le siliciure de nickel. De même, la configuration géométrique de la région ou couche de silicium et la configuration des zones de siliciure la recouvrant pourront être choisies par l'homme de métier. Par exemple, on pourra prévoir des structures à zones de siliciure médiane pour former des ponts diviseurs réglables.

Une autre application de la présente invention réside dans la formation de transistors à effet de champ à seuil ajustable.

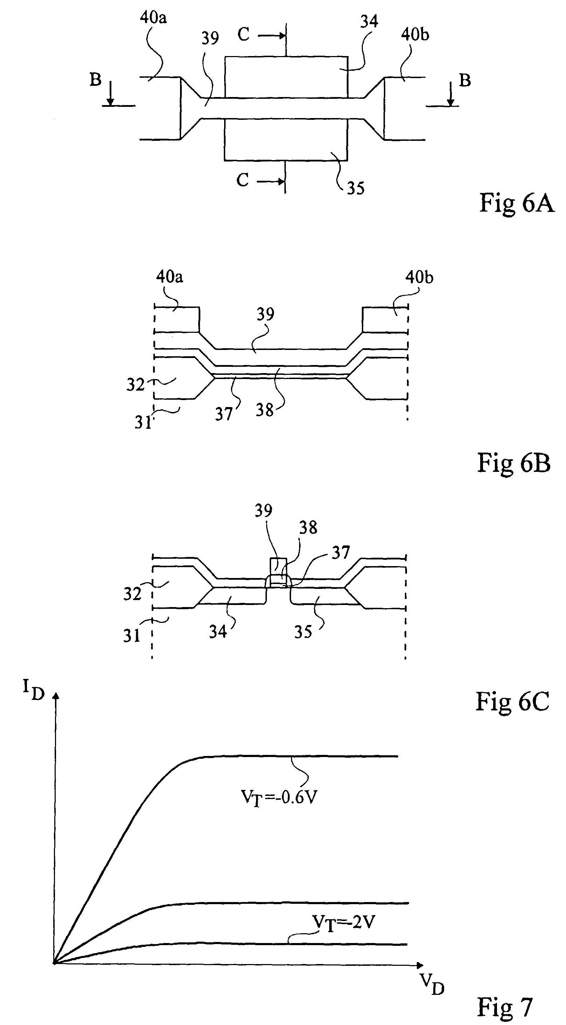

Les figures 6A, 6B et 6C représentent respectivement une vue de dessus, une vue en coupe selon la ligne B-B et une vue en coupe selon la ligne C-C d'un transistor MOS selon la présente invention.

Ce transistor MOS est formé sur un substrat 31 à l'intérieur d'une zone définie par un oxyde épais 32. Il comprend des régions de source et de drain 34 et 35 séparées par une région de grille comprenant un empilement d'une couche d'oxyde de grille 37, d'une couche de silicium polycristallin dopé 38, et d'une couche de siliciure 39. Des contacts, par exemple en aluminium, 40a et 40b sont prévus aux deux extrémités de la bande de siliciure de titane 39.

La présente invention tire partie du fait que le seuil d'un transistor MOS dépend non seulement du dopage de la région de canal ou de l'épaisseur de l'isolant de grille mais aussi, entre autres, de la résistance de la couche de grille (en effet, la présence d'une couche plus résistante au-dessus de l'isolant de grille peut être assimilée à une augmentation de l'épaisseur de cet isolant de grille).

Ainsi, le seuil d'un transistor tel que celui des figures 6A à 6C varie quand la résistance de la couche de silicium polycristallin 38 au-dessus de la grille varie. Pour faire varier cette résistance, on produit un échauffement de la couche de siliciure de titane qui surplombe cette couche de grille. Ceci est de préférence effectué en faisant passer un courant intense entre les contacts 40a et 40b, ce courant étant modulé en fonction du résultat souhaité. Bien entendu, on réalise de préférence l'échauffement de la zone de grille en évitant d'échauffer les zones de drain et de source car, classiquement, ces zones seront également revêtues d'un siliciure et l'on souhaite éviter une augmentation de la résistance de contact de l'interface silicium-siliciure des régions de source et de drain.

Comme le montre la figure 7, on a ainsi obtenu pour un transistor ayant normalement une tension VT de -0,6 volt, des tensions de seuil pouvant décroître jusqu'à -2 volt. La courbe intermédiaire correspondant à un passage de courant plus faible.

Bien entendu, la présente invention est susceptible de nombreuses variantes correspondant aux diverses variantes utilisées pour la fabrication des transistors MOS. Dans l'exemple représenté, on a illustré des espaceurs de part et d'autre d'empilements d'isolant de grille et de silicium polycristallin. Ces espaceurs pourraient être omis dans le cas d'autres techniques de fabrication. Egalement, de façon classique, on pourra utiliser ces espaceurs pour créer des structures de type LDD.

Selon une autre variante de la présente invention, la couche de siliciure polycristallin pourrait être interrompue au niveau de la grille pour augmenter l'échauffement lors d'un passage de courant. Dans ce cas, cette interruption devra être suffisamment faible pour qu'il puisse se produire une exodiffusion du dopant du silicium polycristallin vers le siliciure de titane ou autre siliciure.

De même, diverses variantes décrites en relation avec la réalisation d'une résistance pourront également s'appliquer à la réalisation d'un transistor MOS à seuil ajustable.

## Revendications

1. Procédé de modification du dopage d'une région choisie parmi une pluralité de régions ou couches de silicium dopé, caractérisé en ce qu'il comprend les étapes suivantes :
revêtir la pluralité de régions ou couches de silicium (11 ; 21) d'une couche de siliciure d'un métal réfractaire (14 ; 24 ; 39) ; et
chauffer la région d'interface entre la région choisie de silicium et le siliciure à une température choisie.

2. Procédé selon la revendication 1, caractérisé en ce que le silicium est du silicium monocristallin.

3. Procédé selon la revendication 1, caractérisé en ce que le silicium est du silicium polycristallin.

4. Procédé selon la revendication 1, caractérisé en ce que le siliciure est un siliciure de titane.

5. Procédé selon l'une quelconque des revendications 1 à 4, caractérisé en ce que la température d'échauffement est comprise entre 750 et 1050°C.

6. Procédé selon l'une quelconque des revendications 1 à 5, caractérisé en ce que le chauffage est réalisé par circulation de courant.

7. Procédé selon l'une quelconque des revendications 1 à 5, caractérisé en ce que le chauffage est réalisé par irradiation optique, telle qu'une irradiation laser.

8. Procédé selon l'une quelconque des revendications 1 à 7, caractérisé en ce que la région ou couche de silicium a une épaisseur comprise entre 100 et 400 nanomètres.

9. Procédé selon l'une quelconque des revendications 1 à 8, caractérisé en ce que la région ou couche de silicium a un niveau de dopage de l'ordre de 5.10²⁰ atomes par cm³ et une résistance par carré de l'ordre de 1 à 3 ohms par carré.

10. Procédé selon l'une quelconque des revendications 1 à 8, caractérisé en ce que la couche de siliciure a une épaisseur de l'ordre de 10 à 100 nanomètres.

11. Application du procédé selon l'une quelconque des revendications 1 à 10 à la fabrication d'une résistance ajustable, caractérisé en ce qu'il comprend les étapes suivantes :
prévoir une région ou couche de silicium (11 ; 21) ;
revêtir des extrémités de ladite région ou couche d'un siliciure (14a, 14b ; 24a, 24b) ; et
chauffer les régions d'interface entre le silicium et le siliciure.

12. Application du procédé selon l'une quelconque des revendications 1 à 10 à la fabrication d'un transistor MOS à tension de seuil ajustable, caractérisé en ce qu'il comprend les étapes suivantes :
former un transistor MOS dont la région de grille comprend un empilement d'un isolant de grille (37), de silicium polycristallin (38) et d'une région de siliciure de titane (39) ; et
chauffer les régions d'interface entre le silicium et le siliciure.
